# DEMANDE DE BREVET EUROPEEN

(11) **EP 4 391 374 A1**
(43) Date de publication de la demande: **26.06.2024**
(21) Numéro de dépôt: 23215764.4
(22) Date de dépôt: 12.12.2023
(51) Int. Cl.: H03H 3/04, H03H 3/02, H03H 9/02, H03H 9/56

(54) **PROCÉDÉ DE RÉALISATION D'UN FILTRE À ONDES ACOUSTIQUES DE VOLUME**

(30) Priorité: 13.12.2022 FR 2213250
(71) Demandeur: Commissariat à l'énergie atomique et aux énergies alternatives, 75015 Paris (FR)
(72) Inventeur: REINHARDT, Alexandre, 38054 Grenoble Cedex 09 (FR); BOUSQUET, Marie, 38054 Grenoble Cedex 09 (FR)
(74) Mandataire: Cabinet Camus Lebkiri

(57) **Abrégé**

Un aspect de l'invention concerne un procédé de réalisation d'un filtre passe-bande comprenant un premier résonateur (1) à ondes acoustiques de volume et un deuxième résonateur (2) à ondes acoustiques de volume, la fréquence de résonance du deuxième résonateur étant décalée de la fréquence de résonance du premier résonateur avec un décalage prédéterminé, le procédé comprenant les étapes de :
- fourniture d'un substrat (10) piézoélectrique sur isolant,
- formation d'une électrode inférieure (31) du premier résonateur (1) et d'une électrode inférieure (32) du deuxième résonateur (2),
- assemblage par collage du substrat donneur (10) sur un substrat receveur (50),
- retrait du substrat donneur (10) avec arrêt sur la couche piézoélectrique (13),
- formation d'une électrode supérieure (33) du premier résonateur (1) et d'une électrode supérieure (34),

la formation des électrodes inférieures (31,32) étant précédée d'une étape de formation d'un motif (20) de surcharge massique au niveau de la deuxième zone (134),
et/ou la formation des électrodes supérieures (33,34) étant précédée d'une étape de formation d'un motif (21) de surcharge massique au niveau de la deuxième zone (134),
l'épaisseur totale du ou des motifs (20,21) de surcharge massique étant choisie pour décaler la fréquence de résonance du deuxième résonateur avec le décalage prédéterminé.

## Description

### DOMAINE TECHNIQUE DE L'INVENTION

Le domaine technique de l'invention est celui des filtres radiofréquence basés sur des résonateurs à ondes acoustiques de volume.

La présente invention concerne un procédé de fabrication d'un filtre radiofréquence utilisant plusieurs résonateurs à ondes acoustiques de volume formés sur un même substrat de matériau piézoélectrique.

### ARRIERE-PLAN TECHNOLOGIQUE DE L'INVENTION

Dans le domaine des systèmes de télécommunication, des filtres radiofréquence « large bande » sont nécessaires pour sélectionner le signal radiofréquence utile.

Ainsi, pour des applications de téléphonie mobile de cinquième génération (ou 5G), on cherche à obtenir des filtres ayant une fréquence de fonctionnement comprise entre 3,3 GHz et 6 GHz, une bande passante relative de quelques pourcents, par exemple de 10%, des pertes inférieures à 3 dB dans la bande passante et supérieures à 45 dB dans les bandes de réjection, c'est-à-dire hors de la bande passante.

Pour cela, des solutions basées sur des matériaux piézoélectriques sont développées. Les filtres à ondes acoustiques de volume utilisant plusieurs résonateurs à ondes acoustiques de volume, aussi désignés par résonateurs BAW pour « Bulk Acoustic Wave » selon la terminologie anglaise, sont un exemple de solutions adaptées aux standards de la téléphonie mobile.

Les résonateurs BAW exploitent la propagation des ondes acoustiques dans des couches piézoélectriques. De façon générale, un résonateur BAW comprend un empilement de couches formées sur un substrat et comprenant une électrode inférieure et une électrode supérieure encadrant une portion d'une couche formée d'un matériau piézoélectrique, dite couche piézoélectrique. Par ailleurs cet empilement de couches est isolé mécaniquement du substrat par un empilement de couches formant un dispositif mécaniquement isolant. Ce dispositif peut être une lame d'air, auquel cas le résonateur BAW est appelé résonateur FBAR pour « Film Bulk Acoustic Resonator » selon la terminologie anglaise. Alternativement, le dispositif peut être une structure de miroirs de Bragg, auquel cas le résonateur BAW est appelé résonateur SMR pour « Solidly Mounted resonator » selon la terminologie anglaise.

Un type de filtre à ondes acoustiques de volume dont la topologie est dite « en échelle » ou « ladder » selon la terminologie anglaise est particulièrement utilisé, du fait de sa simplicité et de son adaptabilité.

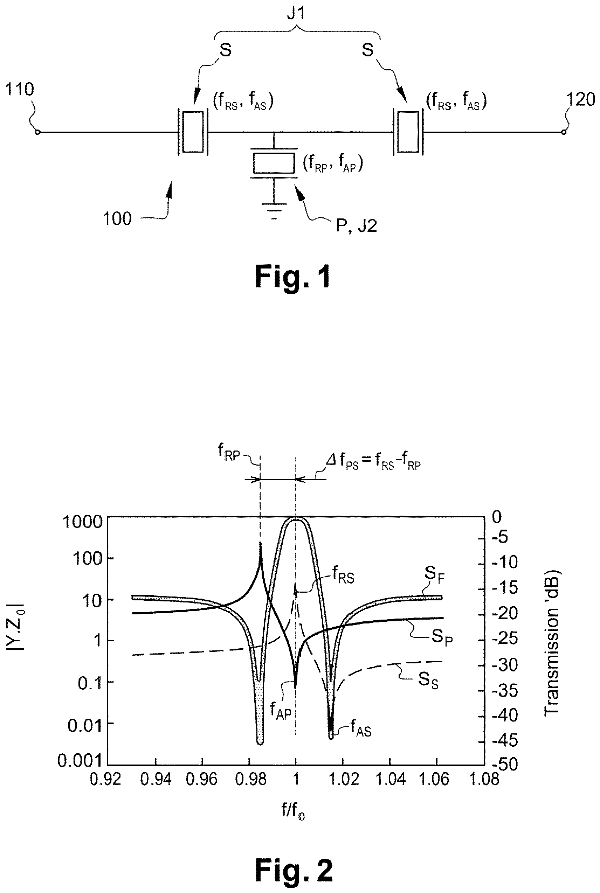

En référence à la figure 1, un tel filtre 100 en échelle comprend un premier jeu J1 de résonateurs S à ondes acoustiques de volume disposés en série entre une entrée 110 et une sortie 120, et un deuxième jeu J2 comprenant un résonateur P à ondes acoustiques de volume disposé en parallèle et reliés à la masse.

Par souci de simplification, les résonateurs S à ondes acoustiques de volume en série sont appelés résonateurs S série, et le résonateur P à ondes acoustiques de volume en parallèle est appelé résonateur P parallèle.

Les résonateurs S série présentent tous la même fréquence de résonance f_{RS} qui correspond à la fréquence de fonctionnement f₀ désirée pour le filtre 100. Les résonateurs S série présentent en conséquence tous la même fréquence d'antirésonance f_{AS}.

La fréquence de résonance f_{RP} du résonateur P parallèle est quant à elle décalée de la fréquence de résonance f_{RS} des résonateurs S série vers une fréquence inférieure, le décalage Δ*f*_{PS} étant prédéterminé pour que la fréquence d'antirésonance f_{AP} du résonateur P parallèle corresponde à la fréquence de résonance f_{RS} du résonateur S série. Dit autrement, le décalage est égal au résultat de la différence entre la fréquence d'antirésonance f_{AS} et la fréquence de résonance f_{RS} du résonateur S série.

La réponse électrique S_{F} d'un tel filtre 100 est donnée en figure 2. La réponse S_{S} des résonateurs S série ainsi que celle S_{P} du résonateur P parallèle sont également affichées. A la fréquence de résonance f_{RS} des résonateurs S série, le signal électrique S_{F} généré par le filtre, via les résonateurs S série, est maximal. A l'inverse, à la fréquence d'anti-résonance f_{AS} des résonateurs série, le signal électrique S_{F} est redirigé vers la masse ou bloqué en entrée du fait des résonateurs en série qui présentent une grande impédance, ce qui conduit à une atténuation maximale du signal S_{F}. Loin de ces fréquences de résonance f_{RS} et d'antirésonance f_{AS}, le filtre se comporte comme un pont capacitif venant atténuer le signal S_{F}.

Pour qu'un tel filtre 100 atteigne les spécifications large bande décrites précédemment, plusieurs exigences sont requises.

Une première exigence concerne le matériau piézoélectrique. Ses propriétés électromécaniques déterminent en effet en partie les performances du filtre, en particulier sa bande passante et ses pertes, au travers d'un facteur de qualité Q (ou facteur de mérite) et d'un coefficient de couplage électromécanique k² (ou kₜ²) caractéristiques du filtre.

Le nitrure d'aluminium AlN et le nitrure d'aluminium et de scandium (Al₁₋ₓScₓN) déposés en couche minces, bien que couramment utilisés dans l'industrie, ne sont pas des matériaux piézoélectriques adaptés. Le coefficient de couplage électromécanique intrinsèque du nitrure d'aluminium, qui est de l'ordre de 7,5%, est en effet trop faible. Quant au nitrure d'aluminium et de scandium, si son coefficient de couplage électromécanique intrinsèque augmente avec la concentration en scandium, ses pertes mécaniques augmentent également, ce qui ne permet plus la synthèse de filtres présentant des pertes d'insertion satisfaisantes.

Il est donc nécessaire de remplacer ces matériaux par des matériaux présentant de meilleures performances électromécaniques intrinsèques.

Le niobate de lithium est l'un de ces matériaux.

Le document « Large electromechanical coupling factor film bulk acoustic resonator with x-cut LiNbOs layer transfer » de Pijolat et al., Applied Physics Letters, 2009 a ainsi montré qu'une couche mince de 6,6 µm d'épaisseur de Niobate de lithium formée par transfert de couche présente un coefficient de couplage électromécanique supérieur à six fois le coefficient de couplage du nitrure d'aluminium (45% par rapport à 7,5% pour l'AlN), permettant d'envisager une bande passante jusqu'à six fois plus large que la bande passante des filtres en nitrure d'aluminium.

Le document « High frequency LiNbOs bulk Wave resonator » de Gorisse et al., IEEE international Frequency Control Symposium, 2019 basé sur le brevet EP2330737B1 décrit une manière de fabriquer un résonateur à ondes acoustiques de volume basé sur un tel matériau piézoélectrique. Le procédé de fabrication comprend 1) la fourniture d'un substrat donneur comprenant une couche de niobate de lithium présentant une orientation cristalline selon le plan de coupe X, 2) l'implantation d'ions à une profondeur déterminée du substrat donneur pour y former un plan fragile, 3) la formation d'une électrode inférieure sur la couche de niobate de lithium, 4) le transfert du substrat donneur sur un substrat receveur, laissant l'empilement comprenant l'électrode inférieure et la couche de niobate de lithium sur le substrat receveur, et 5) la formation d'une électrode supérieure sur la couche piézoélectrique, au niveau de la zone définie par l'électrode inférieure. Un tel procédé contourne avantageusement la difficulté à déposer ou à graver le niobate de lithium.

Une autre exigence pour obtenir un filtre large bande avec les spécifications précitées concerne la capacité à décaler la fréquence de résonance d'un résonateur parallèle par rapport à la fréquence de résonance d'un résonateur série avec l'amplitude et la précision suffisantes.

Plusieurs techniques permettant de décaler la fréquence de l'un des résonateurs sont décrites. Toutes reposent sur le principe consistant à faire varier, dans l'un des résonateurs P,S parallèle ou série, l'épaisseur totale du résonateur.

Toutes ces techniques sont principalement décrites pour des filtres dont le matériau piézoélectrique est le nitrure d'aluminium. Or le niobate de lithium présente des propriétés physiques et chimiques différentes du nitrure d'aluminium. Certaines des techniques bien connues de l'art antérieur ne sont ainsi pas adaptées au niobate de lithium.

Parmi les techniques non adaptées, figurent une première famille de techniques consistant à faire varier l'épaisseur de la couche de matériau piézoélectrique et une deuxième famille de techniques consistant à faire varier l'épaisseur d'une électrode par des étapes successives de dépôt et de gravure d'une couche métallique sur toute la surface de la couche piézoélectrique.

La première famille de techniques utilise des procédés de dépôt de couche piézoélectrique (pour augmenter l'épaisseur) sur la couche piézoélectrique déjà formée, ou des procédés de gravure de la couche piézoélectrique (pour diminuer l'épaisseur). Or le niobate de lithium n'est pas aisé à déposer. Par ailleurs, sa gravure peut rapidement abimer la surface du matériau (en provoquant sa rugosification ou son amorphisation), ce qui entraine une perte de ses propriétés piézoélectriques. De plus, les procédés de gravure sont relativement inhomogènes à l'échelle d'un substrat, ce qui empêche d'atteindre la précision et l'uniformité (soit moins de 1% de variation à l'échelle d'un substrat) requises pour satisfaire les tolérances sur les dispersions de fréquence du filtre.

La deuxième famille de techniques, décrite par exemple dans le brevet US6617249B2 consiste précisément à 1) déposer une première couche métallique sur l'ensemble de la couche de matériau piézoélectrique, puis 2) à déposer, sur cette première couche et sur une surface correspondant au résonateur P parallèle, une couche de surcharge massique métallique permettant d'augmenter l'épaisseur de l'électrode supérieure du résonateur P parallèle. Les électrodes supérieures des résonateurs S, P série et parallèle sont ensuite définies par gravure commune de la première couche métallique et de la couche de surcharge massique.

Si le fait de déposer puis de graver une première couche d'électrode sur une couche piézoélectrique en nitrure d'aluminium n'induit pas une dégradation du nitrure d'aluminium, il n'en va pas de même lorsque la couche piézoélectrique est en niobate de lithium. En effet, la compatibilité chimique entre les électrodes, notamment si celles-ci sont formées d'aluminium, et le niobate de lithium est différente. Ainsi, le dépôt de la première couche d'électrode à la surface d'une couche du niobate de lithium, puis son retrait par gravure chimique laisse des résidus visibles à la surface de la couche piézoélectrique. Ces résidus, qui sont des signes de l'inter-diffusion entre l'aluminium et le matériau piézoélectrique, induisent une rugosité non désirée et peuvent perturber la propagation d'ondes acoustiques. Par ailleurs, l'inter-diffusion entre l'aluminium et le matériau piézoélectrique conduit à la formation d'un oxyde mixte, se comportant comme une couche morte venant dégrader les propriétés piézoélectriques de la couche piézoélectrique.

Parmi les techniques adaptées au niobate de lithium, figurent une troisième, une quatrième et une cinquième famille de techniques.

La troisième famille de techniques consiste soit à amincir l'une des électrodes du résonateur S série une fois celle-ci formée, soit à augmenter la charge massique de l'une des électrodes du résonateur P parallèle une fois celle-ci formée.

L'amincissement d'une électrode consiste à graver partiellement cette électrode. Cependant, les procédés de gravure des électrodes ne permettent pas d'atteindre l'épaisseur souhaitée pour l'électrode avec la tolérance souhaitée (moins de 1%). De plus, l'amincissement des électrodes conduit à une augmentation de leur résistivité, ce qui augmente les pertes résistives dans le circuit du filtre. Une alternative, proposée dans le brevet US6617249B2, consiste à oxyder en surface l'électrode. Là aussi, l'oxyde métallique est électriquement moins conducteur que le métal de l'électrode, ce qui dégrade la performance de cette électrode. Ainsi, la troisième technique présente l'inconvénient de dégrader les performances du filtre.

La quatrième famille de techniques consiste à faire varier l'épaisseur de la couche support se trouvant sous le résonateur P parallèle.

Le brevet US6842089B2 décrit ainsi la réalisation, avant la fabrication des résonateurs, d'une série de masquages et de gravure sur le substrat pour augmenter l'épaisseur de la couche support se trouvant sous le résonateur parallèle. La variation d'épaisseur de la couche support, du fait qu'elle est éloignée de la couche piézoélectrique, est importante, et influe négativement sur le coefficient de couplage électromécanique du résonateur P parallèle. Une raison est que tout ajout de matière sous ou à proximité du résonateur tend à stocker de l'énergie mécanique en dehors de la couche piézoélectrique, qui n'est alors pas convertie en énergie électrique, la conversion n'ayant lieu que dans la couche de matériau piézoélectrique. Le coefficient électromécanique du résonateur P parallèle ainsi formé est alors dégradé.

Le brevet US6617249B2 décrit le fait de modifier une épaisseur de couche plus proche de la couche piézoélectrique. Précisément, ce brevet décrit une solution consistant à déposer une couche, dite couche de surcharge massique, sous l'électrode inférieure d'un résonateur en parallèle. Pour cela, le dépôt de la couche de surcharge massique est réalisé sur une couche de substrat, avant l'étape de formation de l'électrode inférieure. Bien que la variation d'épaisseur soit plus proche de la couche piézoélectrique que la solution décrite précédemment, le coefficient électromécanique du résonateur ainsi formé reste dégradé.

La cinquième famille de techniques consiste à déposer une couche de surcharge massique métallique sur l'électrode supérieure du résonateur P autrement qu'en utilisant un dépôt/retrait d'une couche métallique sur toute la surface de la couche piézoélectrique.

Le brevet US5894647B1 décrit ainsi une première combinaison d'étapes de photolithographie et de gravure pour former les électrodes supérieures des résonateurs S, P série et parallèle par-dessus la couche de matériau piézoélectrique, puis une deuxième combinaison de photolithographie et de gravure pour déposer une couche de surcharge massique uniquement sur l'électrode supérieure du résonateur parallèle. Un inconvénient est que des défauts d'alignement entre l'électrode supérieure et la couche de surcharge massique peuvent se produire, engendrant des régions appelées « débords » où l'électrode supérieure n'est pas recouverte de la couche de surcharge massique, et/ou des régions où la couche de surcharge massique est au contact de la couche piézoélectrique. Ces régions se comportent comme des résonateurs et introduisent des résonances parasites néfastes pour les performances du filtre.

Pour y remédier et définir la structure souhaitée pour l'électrode supérieure du résonateur P parallèle, le même brevet décrit le fait de réaliser une nouvelle photolithographie et un nouveau dépôt d'une couche de surcharge massique sur une zone plus large que la zone définie pour le résonateur P parallèle, et de graver les régions précitées ainsi que les bords de la région où la couche d'électrode et la couche de surcharge massique se superposent. La gravure de la couche de surcharge massique est alors nécessairement une gravure sélective vis-à-vis du métal de l'électrode, ce qui impose donc d'utiliser, pour la couche de surcharge massique et pour les électrodes, des métaux ayant des chimies de gravure différentes. L'inconvénient est que des composés intermétalliques résistants aux chimies de gravure peuvent se former à la surface du matériau piézoélectrique. Il est alors nécessaire de prévoir un niveau de masque supplémentaire pour pouvoir graver de façon non sélective les débords des électrodes, ce qui est complexe à réaliser.

Le brevet US6472954B1 propose une manière de contourner ce problème en décrivant une étape de formation d'une couche de surcharge massique réalisée après la formation des résonateurs (et donc de l'électrode supérieure du résonateur P parallèle) et comprenant une étape de dépôt d'une couche sacrificielle structurée avec un motif de chargement localisé sur l'électrode supérieure du résonateur P parallèle, une étape de dépôt de la couche de surcharge massique sur la couche sacrificielle structurée, et une étape de retrait par lift-off de la couche sacrificielle et de la couche de surcharge métallique déposée.

Le brevet US7802349B2 du même auteur décrit plus spécifiquement que la couche sacrificielle est un masque en résine, et que le retrait de ce masque est effectué sans gravure, par chimie dite « douce » à base d'une solution adaptée aux résines.

Grâce à la couche sacrificielle, le matériau piézoélectrique est préservé des phénomènes d'inter-diffusion lors de la formation de la couche de surcharge massique. Cependant, le retrait de cette couche sacrificielle pose le problème de préserver les électrodes supérieures des résonateurs du filtre. En effet, le retrait de la couche sacrificielle nécessite d'utiliser des solutions qui sont généralement agressives vis-à-vis du matériau métallique utilisé pour les électrodes. Des fissures et des points faibles peuvent ainsi apparaître sur les électrodes sous l'effet combiné des agents chimiques et des conditions de température, ce qui dégrade les performances des résonateurs et, donc, du filtre. L'aluminium est en particulier très sensible à ces solutions, le molybdène également, même si dans une moindre mesure. Les électrodes supérieures des résonateurs en parallèle peuvent donc être endommagées.

Il existe donc un besoin d'améliorer les techniques existantes décrivant l'ajustement de la fréquence de résonance d'un résonateur P parallèle pour réaliser un filtre large bande adapté aux applications de téléphonie mobile.

### RESUME DE L'INVENTION

L'invention offre une solution aux problèmes évoqués précédemment, en prévoyant un procédé de réalisation qui préserve les électrodes des résonateurs et peut s'affranchir d'une succession d'étapes de dépôt et de retrait d'une couche métallique sur toute la surface de la couche piézoélectrique, et qui est compatible avec l'utilisation d'un matériau piézoélectrique monocristallin comme le niobate de lithium.

Pour cela, le procédé selon l'invention débute avec la fourniture d'un substrat piézoélectrique sur isolant et utilise une étape d'assemblage intercalée entre la réalisation de la partie inférieure et de la partie supérieure des résonateurs. Par ailleurs, le procédé permet d'épaissir l'électrode inférieure et/ou l'électrode supérieure du résonateur parallèle avant la formation desdites électrodes.

Un aspect de l'invention concerne un procédé de réalisation d'un filtre passe-bande comprenant un premier résonateur à ondes acoustiques de volume et un deuxième résonateur à ondes acoustiques de volume, la fréquence de résonance du deuxième résonateur étant décalée de la fréquence de résonance du premier résonateur avec un décalage prédéterminé, le procédé comprenant les étapes de :
- fourniture d'un substrat piézoélectrique sur isolant, dit substrat donneur, comprenant en partie supérieure une couche piézoélectrique,
- formation d'une électrode inférieure du premier résonateur sur une première zone prédéfinie de la couche piézoélectrique, et d'une électrode inférieure du deuxième résonateur sur une deuxième zone prédéfinie de la couche piézoélectrique,
- assemblage par collage du substrat donneur sur un substrat receveur, de sorte que les électrodes inférieures des premier et deuxième résonateurs sont disposées entre le substrat receveur et le substrat donneur,
- retrait, dans l'assemblage du substrat receveur et du substrat donneur, du substrat donneur avec arrêt sur la couche piézoélectrique,
- formation, sur la couche piézoélectrique, d'une électrode supérieure du premier résonateur au niveau de la première zone, et d'une électrode supérieure du deuxième résonateur au niveau de la deuxième zone,
la formation des électrodes inférieures étant précédée d'une étape de formation d'un motif de surcharge massique au niveau de la deuxième zone, dit motif de surcharge massique de l'électrode inférieure, et/ou la formation des électrodes supérieures étant précédée d'une étape de formation d'un motif de surcharge massique au niveau de la deuxième zone, dit motif de surcharge massique de l'électrode supérieure, l'épaisseur totale du ou des motifs de surcharge massique étant choisie pour décaler la fréquence de résonance du deuxième résonateur avec le décalage prédéterminé, chaque motif de surcharge massique étant formé par lift-off d'une couche sacrificielle formée préalablement sur la couche piézoélectrique.

Ainsi, l'association de la fourniture d'un substrat piézoélectrique sur isolant, et d'une étape d'assemblage intercalée entre la formation de la partie inférieure des résonateurs (incluant les électrodes inférieures) et la formation de la partie supérieure des résonateurs (incluant les électrodes supérieures) permet d'utiliser des matériaux piézoélectriques monocristallins, tels que le niobate de lithium, le tantalate de lithium, etc., obtenus par transfert de couche. Comme ces matériaux présentent des propriétés piézoélectriques intrinsèques supérieures au nitrure d'aluminium, ils sont compatibles avec la synthèse d'un filtre large bande.

Cette caractéristique a aussi pour effet de rendre accessible les deux faces (inférieure, supérieure) de la couche piézoélectrique. Cela permet d'ajuster l'épaisseur de l'une ou l'autre des électrodes du deuxième résonateur, ou d'ajuster l'épaisseur de l'une et l'autre des électrodes du deuxième résonateur. La possibilité de faire varier l'épaisseur des deux électrodes inférieures/supérieures trouve un avantage particulier pour augmenter la bande passante du filtre. Cette caractéristique apporte une amélioration par rapport aux techniques existantes.

Par ailleurs, la formation des électrodes inférieures est précédée d'une étape de formation d'un motif de surcharge massique au niveau de la deuxième zone, et/ou la formation des électrodes supérieures est précédée d'une étape de formation d'un motif de surcharge massique au niveau de la deuxième zone, les motifs de surcharge massiques étant obtenus par dépôt d'une couche de surcharge massique. L'épaisseur totale du ou des motifs de surcharge massique est choisie pour décaler la fréquence de résonance du deuxième résonateur avec le décalage prédéterminé.

Comme la deuxième zone comprend la zone de la couche piézoélectrique correspondant au deuxième résonateur, les électrodes du deuxième résonateur sont épaissies par un motif de surcharge massique disposé comme suit :
- Lorsque l'électrode inférieure est épaissie, le motif de surcharge métallique est intercalé entre la couche piézoélectrique et l'électrode inférieure,
- Lorsque l'électrode supérieure est épaissie, le motif de surcharge massique est intercalé entre la couche piézoélectrique et l'électrode supérieure,
- Lorsque les deux électrodes sont épaissies, un premier motif de surcharge massique est intercalé entre la couche piézoélectrique et l'électrode inférieure, et un deuxième motif de surcharge massique est intercalé entre la couche piézoélectrique et l'électrode supérieure.

L'avantage d'une telle disposition réside dans le fait que la variation d'épaisseur est obtenue au plus près de la couche piézoélectrique, ce qui permet de préserver au mieux le coefficient de couplage électromécanique du deuxième résonateur, et donc d'améliorer les performances du filtre. Il convient de noter que cette caractéristique est différenciante par rapport à l'art antérieur, qui décrit une couche de surcharge massique disposée sur l'électrode supérieure ou sous l'électrode inférieure, donc plus éloignée de la couche piézoélectrique.

Enfin, comme les motifs de surcharge massique sont formés avant la formation des électrodes, la formation des motifs ne peut pas endommager le métal des électrodes. Les électrodes des résonateurs sont donc préservées.

Pour ces raisons au moins, le procédé selon l'invention permet d'améliorer les techniques existantes décrivant l'ajustement de la fréquence de résonance d'un résonateur, tout en étant compatible avec l'utilisation d'un matériau piézoélectrique monocristallin. Le procédé selon l'invention est ainsi adapté pour réaliser un filtre large bande selon les spécifications requises par exemple pour la téléphonie mobile.

Avantageusement, la formation de chaque motif de surcharge massique par lift-off d'une couche sacrificielle formée préalablement sur la couche piézoélectrique comprend les sous-étapes suivantes :
- dépôt d'une couche sacrificielle sur toute la surface de la couche piézoélectrique,
- définition d'une ouverture à travers la couche sacrificielle au niveau de la deuxième zone, l'ouverture débouchant sur la couche piézoélectrique au niveau de ladite deuxième zone,
- dépôt d'une couche de surcharge massique de sorte à recouvrir la couche piézoélectrique uniquement au niveau de l'ouverture et à recouvrir la couche sacrificielle en dehors de l'ouverture,
- retrait de l'empilement formé par la couche sacrificielle et la couche de surcharge massique par retrait par lift-off de la couche sacrificielle, ledit retrait laissant la couche de surcharge massique sur la couche piézoélectrique uniquement au niveau de la deuxième zone pour former le motif de surcharge massique.

Ainsi, le ou les motifs de surcharge massique sont formés en s'affranchissant d'une opération de gravure susceptible d'engendrer des phénomènes d'inter-diffusion pouvant dégrader la couche piézoélectrique. La couche sacrificielle permet donc de protéger (préserver) la couche piézoélectrique des résonateurs et, ainsi de préserver ses propriétés piézoélectriques intrinsèques.

Avantageusement, le motif de surcharge massique de l'électrode inférieure est formé d'un matériau identique au motif de surcharge massique de l'électrode supérieure et présente une épaisseur identique audit motif de surcharge massique de l'électrode supérieure.

Ainsi, deux couches de surcharge massique sont disposées de façon symétrique entre respectivement la couche piézoélectrique et l'électrode inférieure du deuxième résonateur, et la couche piézoélectrique et l'électrode supérieure du deuxième résonateur. Dit autrement, le deuxième résonateur présente une structure symétrique par rapport à un plan central de la couche piézoélectrique.

Cette caractéristique trouve un avantage pour atteindre une large bande passante sans augmenter les pertes dans cette bande passante. En effet, pour atteindre certaines larges bandes passantes, la quantité de masse est telle qu'elle nécessite une couche de surcharge massique relativement épaisse par rapport aux autres couches. Cela dégraderait la symétrie du deuxième résonateur, et engendrerait une diminution du coefficient de couplage électromécanique et également l'excitation de modes de vibrations asymétriques, l'un limitant la possibilité d'atteindre une large bande passante, l'autre limitant la réjection au niveau des fréquence d'excitation des modes de vibration antisymétriques. En distribuant cette quantité de masse de façon symétrique entre les deux couches de surcharge massique de l'électrode inférieure et supérieure, ces phénomènes de résonances parasites et de dégradation du coefficient de couplage électromécanique sont évités.

Avantageusement, le motif de surcharge massique de l'électrode inférieure est formé d'un matériau identique au matériau des électrodes inférieures, et le motif de surcharge massique de l'électrode supérieure est formé d'un matériau identique au matériau des électrodes supérieures, et la deuxième zone est latéralement plus étendue que le deuxième résonateur.

Ainsi, le deuxième résonateur peut être latéralement redéfini en fin de réalisation du filtre pour éliminer de potentiels phénomènes de résonance parasites sur ses bords. Du fait qu'un même matériau est utilisé pour la couche de surcharge massique et l'électrode qui lui est associée, la redéfinition du deuxième résonateur peut être réalisée par un retrait en une seule étape de l'empilement formé de la couche de surcharge massique et de l'électrode situé autour de la zone définie pour le deuxième résonateur. Ce retrait est simple à réaliser car il n'engendre pas de composés intermétalliques compliquant la gravure.

Avantageusement, le procédé peut comprendre la formation d'une structure d'isolation mécanique sous le premier résonateur et d'une structure d'isolation mécanique sous le deuxième résonateur.

Les structures d'isolation mécanique isolent les résonateurs du substrat receveur et leur permettent de fonctionner.

Selon une première variante de réalisation, le procédé comprend une étape de formation d'une structure de Bragg sur l'électrode inférieure du premier résonateur et d'une structure de Bragg sur l'électrode inférieure du deuxième résonateur, ladite étape de formation des structures de Bragg étant réalisée entre la formation des électrodes inférieures et l'étape d'assemblage.

Les structures de Bragg sont des structures d'isolation mécanique permettant d'isoler les résonateurs du substrat receveur.

Selon une deuxième variante de réalisation, le procédé comprend des étapes pour former une cavité d'air du premier résonateur et une cavité d'air du deuxième résonateur, lesdites étapes étant les suivantes :
- entre la formation des électrodes inférieures et l'étape d'assemblage, formation d'un caisson sur et autour de l'électrode inférieure du premier résonateur, et d'un caisson sur et autour de l'électrode inférieure du deuxième résonateur, les caissons comprenant une couche sacrificielle
- après l'étape d'assemblage et avant la formation des électrodes supérieures, formation à travers la couche piézoélectrique d'une ouverture pour atteindre le caisson situé sur et autour de l'électrode inférieure du premier résonateur, et d'une ouverture pour atteindre le caisson situé sur et autour de l'électrode inférieure du deuxième résonateur,
- après l'étape de formation des électrodes supérieures, retrait de la couche sacrificielle au travers des ouvertures pour libérer les caissons et les emplir d'air.

Les cavités d'air permettant d'isoler les résonateurs du substrat receveur.

Avantageusement, le procédé comprend, après l'étape de formation des électrodes supérieures, une étape supplémentaire de dépôt en face supérieure du filtre passe-bande et uniquement sur les électrodes supérieures, d'une couche métallique, dite couche de sur-métallisation.

Cette couche de sur-métallisation vise à consolider les électrodes électriquement, la couche métallique limitant les pertes résistives des électrodes supérieures.

Outre les caractéristiques qui viennent d'être évoquées dans les paragraphes précédents, le procédé selon un aspect de l'invention peut présenter une ou plusieurs caractéristiques complémentaires parmi les suivantes, considérées individuellement ou selon toutes les combinaisons techniquement possibles :
- La couche piézoélectrique est formée d'un matériau piézoélectrique monocristallin.
- Le matériau piézoélectrique monocristallin est choisi parmi l'un des matériaux suivants : niobate de lithium, tantale de lithium, niobate de potassium, nitrure d'aluminium et de scandium monocristallin.
- Les électrodes inférieures et supérieures sont formées de l'un des matériaux suivants : aluminium, molybdène, tungstène, ruthénium, iridium.

L'invention et ses différentes applications seront mieux comprises à la lecture de la description qui suit et à l'examen des figures qui l'accompagnent.

### BREVE DESCRIPTION DES FIGURES

Les figures sont présentées à titre indicatif et nullement limitatif de l'invention.
- La figure 1 représente schématiquement la structure d'un filtre passe-bas de l'art antérieur, ledit filtre utilisant deux résonateurs à ondes acoustiques de volume disposés en série, et un résonateur à ondes acoustiques de volume disposés en parallèle,
- La figure 2 représente la réponse électrique en fonction de la fréquence du filtre de la figure 1, ainsi que les réponses électriques individuelles des résonateurs série et parallèle de la figure 1,
- Les figures 3A à 3I représentent schématiquement des étapes d'un procédé selon un premier mode de réalisation de l'invention,
- Les figures 4A à 4D représentent schématiquement des sous-étapes de la deuxième étape du procédé de la figure 3B,
- Les figures 5A à 5I représentent schématiquement des étapes d'un procédé selon un deuxième mode de réalisation de l'invention,
- Les figures 6A à 6J représentent schématiquement des étapes d'un procédé selon un troisième mode de réalisation de l'invention.

### DESCRIPTION DETAILLEE

Il convient de rappeler au préalable que, de façon générale et bien connue de l'homme du métier, un filtre passe-bande est réalisé à partir d'au moins deux résonateurs à ondes acoustiques de volume couplés électriquement et arrangés dans une structure dite en échelle. Ces deux résonateurs présentent un décalage de leurs fréquences de résonance qui est obtenu en dimensionnant une couche de surcharge massique formée au niveau de l'électrode inférieure ou de l'électrode supérieure de l'un des résonateurs.

L'épaisseur totale de la couche de surcharge massique détermine le décalage fréquentiel entre les fréquences de résonance des deux résonateurs. Le contrôle de l'épaisseur (tolérance) détermine la précision de ce décalage.

Si des performances large bande sont requises pour le filtre, il est nécessaire de former une épaisseur de couche de surcharge massique de l'ordre de 100 nm à 150 nm avec une tolérance inférieure à 2 nm, cela sans détériorer ni la couche piézoélectrique ni les électrodes. Par « performances large bande » on entend une fréquence de fonctionnement comprise entre 3,3 GHz et 6 GHz, une bande passante comprise entre 330 MHz et 600 MHz, des pertes inférieures à 3 dB dans la bande passante et supérieures à 45 dB dans les bandes de réjection.

Dans la suite de la description, on appellera arbitrairement « premier résonateur » le résonateur du filtre ne recevant pas de couche de surcharge massique, et « deuxième résonateur » le résonateur du filtre recevant la couche de surcharge massique. En référence à la partie « Arrière-plan de l'invention », le premier résonateur est assimilé au résonateur S série, et le deuxième résonateur au résonateur P parallèle. Par ailleurs, le premier et le deuxième résonateur sont des résonateurs à ondes acoustiques de volume de type FBAR, ou de type SMR.

Le procédé selon l'invention est remarquable notamment en ce que le deuxième résonateur peut recevoir une couche de surcharge massique au niveau de l'une et/ou de l'autre de ses électrodes.

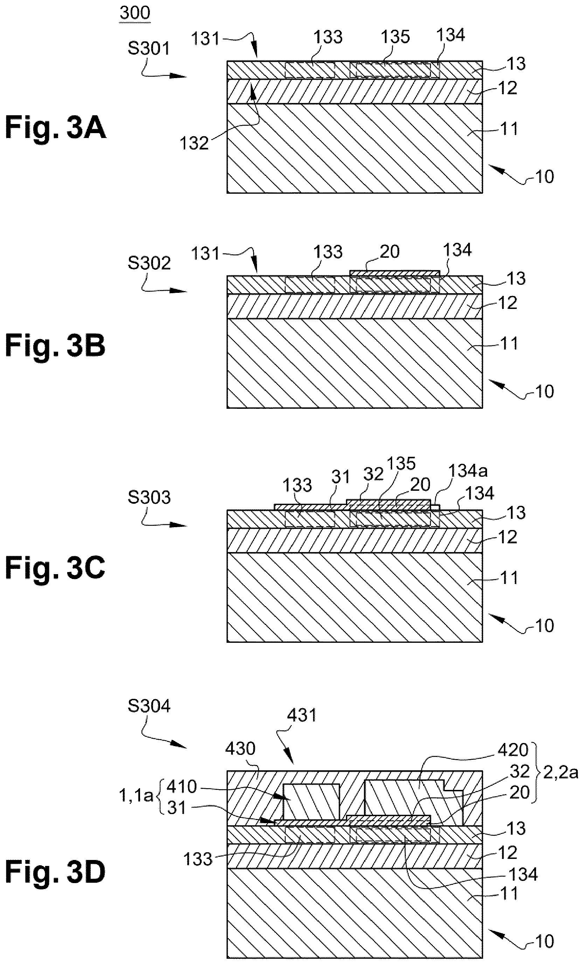

Les figures 3A à 3I représentent schématiquement des étapes d'un procédé 300 selon un premier mode de réalisation de l'invention.

Selon ce premier mode de réalisation et en référence par exemple à la figure 31, le premier et le deuxième résonateur 1,2 sont de type FBAR, et le deuxième résonateur 2 reçoit une couche de surcharge massique 20 au niveau de son électrode inférieure 32.

La première étape S301 illustrée figure 3A consiste à fournir un substrat donneur 10 comprenant sur sa partie supérieure une couche 13 de matériau piézoélectrique, dite couche piézoélectrique 13. La couche 13 piézoélectrique présente une première face 131 et une deuxième face 132 (appelée aussi face supérieure 132) et comprend une première zone 133 dans laquelle sera défini le premier résonateur 1 et une deuxième zone 134 dans laquelle sera défini le deuxième résonateur 2.

La deuxième zone 134 peut comprendre une zone 135, dite zone active 135, prédéfinissant le deuxième résonateur de façon plus précise. La deuxième zone 134 est latéralement plus étendue que la zone active 135.

Il convient de noter que les zones 133, 134 et 135 ne présument pas des dimensions exactes des résonateurs 1,2.

De préférence, le substrat donneur 10 est un substrat piézoélectrique sur isolant 10 ou POI pour « piezoelectric on insulator » selon la terminologie anglaise. Le substrat 10 POI comprend une première couche 11 de substrat, par exemple en silicium, une couche diélectrique 12, par exemple en oxyde de silicium, et la couche piézoélectrique 13.

La couche piézoélectrique 13 est avantageusement formée d'un matériau piézoélectrique monocristallin. La couche piézoélectrique13 est alors formée par une technique connue de transfert de couche sur le substrat 10 POI.

La couche piézoélectrique 13 est par exemple une couche de niobate de lithium présentant une coupe cristalline Y+36° et une épaisseur de 500 nm. Ainsi, la couche piézoélectrique 13 est apte à promouvoir la propagation d'ondes longitudinales avec une vitesse de propagation élevée (7316 m/s) autorisant la synthèse d'un filtre fonctionnant à des fréquences supérieures à 4 GHz. Naturellement, d'autres orientations cristallines peuvent convenir, par exemple des coupes cristallines Z, ou X, ou Y+163°. L'épaisseur de la couche piézoélectrique 13 est alors adaptée en fonction de l'orientation cristalline choisie et des performances désirées pour le filtre.

D'autres matériaux piézoélectriques monocristallins peuvent être choisis, tels que : tantale de lithium LiTaOs, niobate de potassium KNbOs, et de scandium Al₁₋ₓScₓN monocristallin.

La deuxième étape S302 illustrée figure 3B suit la première étape S301. Elle consiste à former un motif 20 de surcharge massique sur la première face 131 de la couche piézoélectrique 13, au niveau de la deuxième zone 134.

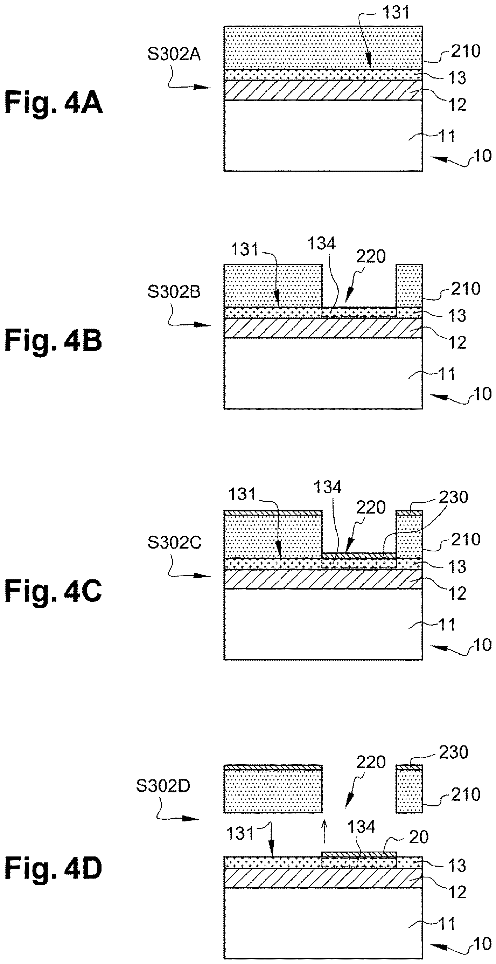

La formation du motif 20 de surcharge massique comprend les sous-étapes S302A, S302B, S302C, et S302D illustrées respectivement en figure 4A, en figure 4B, en figure 4C, et en figure 4D.

La première sous-étape S302A consiste à déposer sur la première face 131 de la couche piézoélectrique 13 une couche sacrificielle 210 de sorte à couvrir toute la surface de la couche piézoélectrique 13. La couche sacrificielle 210 est de préférence une résine photosensible.

La deuxième sous-étape S302B consiste à définir un motif de chargement 220 à travers la couche sacrificielle 210 déposée et au niveau de la deuxième zone 134. Le motif de chargement 220 est une ouverture formée dans la couche sacrificielle 210, sur toute son épaisseur. Il est par exemple défini par insolation et révélation chimique de la couche sacrificielle 210.

A l'issue de cette sous-étape S302B, la couche sacrificielle 210 recouvre la première face 131 à l'exception de la deuxième zone 134 qui est située au niveau du motif de chargement 220.

La troisième sous-étape S302C consiste à déposer une couche de surcharge massique 230 sur toute la surface de la couche sacrificielle 210 structurée avec le motif de chargement.

La couche de surcharge massique 230 est formée d'un matériau métallique, par exemple d'aluminium.

Le matériau métallique choisi pour la couche de surcharge massique 230 est avantageusement identique au matériau choisi pour former l'électrode inférieure 32.

L'épaisseur de la couche de surcharge massique est par exemple de 150 nm.

A l'issue de cette sous-étape S302C, la couche de surcharge massique a atteint la première face 131 de la couche piézoélectrique 13 uniquement au niveau du motif de chargement 220, et a recouvert la surface de la couche sacrificielle 210 où le motif de chargement n'est pas présent.

La quatrième sous-étape S302D consiste à retirer par une technique dite de soulèvement (ou « lift-off » selon la terminologie anglaise), l'empilement formé par la couche sacrificielle 210 et la couche de surcharge massique 230. Plus précisément, la couche sacrificielle 210 est enlevée par dissolution dans un solvant (par exemple un solvant adapté à la résine choisie pour la couche sacrificielle 210). En s'enlevant, la couche sacrificielle 210 soulève la couche de surcharge massique la recouvrant.

A l'issue de la sous-étape S302D, la couche de surcharge massique 230 ne reste qu'au niveau de la deuxième zone 134, là où elle a été en contact direct sur la première face 131 de la couche piézoélectrique 13, et y forme le motif de surcharge massique 20.

Ainsi réalisée, l'étape S302 de formation du motif 20 de surcharge massique préserve la surface de la couche piézoélectrique 13. En effet, cette étape S302 ne nécessite aucune étape de gravure (chimique ou physique) d'une couche métallique sur la première face 131 de la couche piézoélectrique 13. L'absence de gravure permet d'éviter des dommages de type fissures ou rugosités sur cette couche piézoélectrique 13, en particulier si celle-ci est formée de niobate de lithium.

Il convient par ailleurs de noter que les procédés de l'état de l'art ne recourent généralement pas à cette étape S302 du fait que le nitrure d'aluminium, qui est le matériau piézoélectrique le plus couramment utilisé, est endommagé par le solvant utilisé pour dissoudre la couche sacrificielle 210. Ce n'est pas le cas des matériaux piézoélectriques choisis, qui restent sans fissures et lisses après l'application du solvant.

La deuxième étape S302 est suivie d'une troisième étape S303, illustrée figure 3C, consistant à former l'électrode inférieure 31 du premier résonateur 1 et l'électrode inférieure 32 du deuxième résonateur 2.

L'étape S302 comprend pour cela un dépôt d'une couche d'un matériau métallique, celui-ci étant choisi (mais non limité à) parmi les suivants : aluminium, molybdène, tungstène, ruthénium, iridium.

Par exemple, le matériau métallique (et donc les électrodes inférieures 31,32) est l'aluminium.

L'épaisseur de la couche de matériau métallique (et donc des électrodes inférieures 31,32) est par exemple 100 nm.

Le dépôt de la couche métallique est suivi d'une opération de photolithographie - comprenant l'étalement d'une résine, son insolation puis la révélation de motifs -, d'une opération de gravure humide dans une solution adaptée à la couche métallique, et d'une opération de retrait de la résine, le tout pour définir la forme des électrodes inférieures 31,32 du premier et du deuxième résonateur 1,2. L'électrode inférieure 31 du premier résonateur 1 peut être reliée à l'électrode inférieure 32 du deuxième résonateur 2 comme cela est illustré en figure 3C, ou elle peut être séparée de cette électrode inférieure 32 du deuxième résonateur 2.

Il convient de noter que l'opération de gravure est effectuée en dehors de la première zone 133 définie pour le premier résonateur 1 et en dehors de la zone active 135 prédéfinie pour le deuxième résonateur 2.

Lorsque la deuxième zone 134 est plus étendue que la zone active 135, l'opération de gravure pour définir les électrodes inférieures 31,32 est aussi effectuée au niveau du motif 20 de surcharge massique, dans la zone 134a de la deuxième zone 134 adjacente à la zone active 135.

Lorsque la couche de surcharge massique 230 est formée d'un matériau identique aux électrodes inférieures 31,32 (comme illustré en figure 3C), cette opération de gravure est réalisée en une seule étape. Cela simplifie le procédé car il n'est pas nécessaire de prévoir des chimies de gravure différentes. Par ailleurs, cela évite le risque de former des composés intermétalliques sur la couche piézoélectrique à proximité du deuxième résonateur 2.

A l'issue de cette étape S303, les électrodes inférieures 31,32 du premier et deuxième résonateur 1,2 sont donc bien définies et la couche piézoélectrique 13 est préservée de contaminants intermétalliques au niveau de la première zone 133 et de la zone active 135.

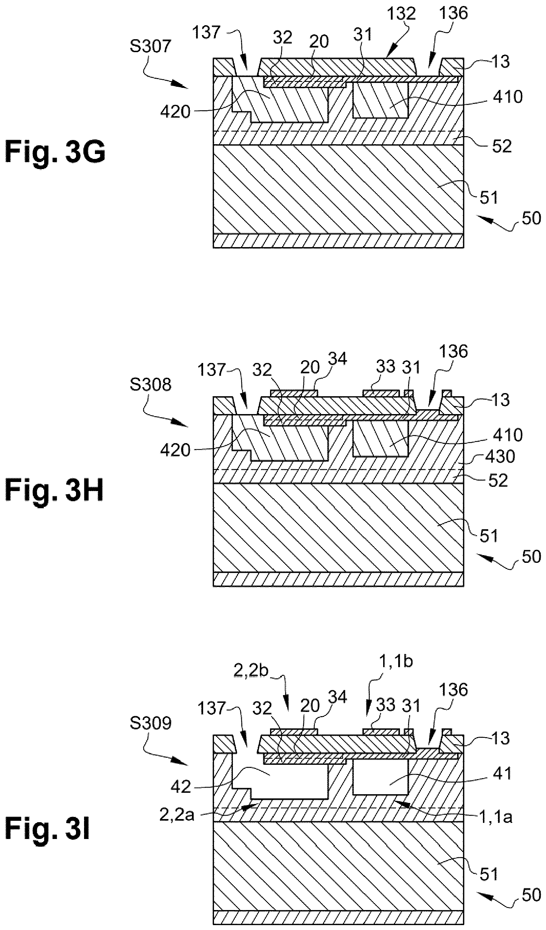

L'étape S303 est suivie d'une étape S304 illustrée en figure 3D, permettant de débuter la formation d'une structure d'isolation mécanique 41 (cf. figure 3I) de type cavité au niveau de la première zone 133, et une structure d'isolation mécanique 42 de type cavité au niveau de la deuxième zone 134.

Pour cela, l'étape S304 consiste à former un caisson 410, dit caisson de libération sur et autour de l'électrode inférieure 31 du premier résonateur 1, et un autre caisson 420 de libération sur et autour de l'électrode inférieure 32 du deuxième résonateur 2.

Pour cela, un dépôt d'une couche sacrificielle d'une épaisseur par exemple de 300 nm est réalisé. La couche sacrificielle est formée de préférence de silicium amorphe. Ensuite, une photolithographie, une gravure sèche, puis un retrait de résine sont successivement effectués pour définir la forme des caissons de libération 410,420.

L'étape S304 se termine par le dépôt d'une couche 430 diélectrique, par exemple d'oxyde de silicium, par exemple par une technique de dépôt chimique en phase vapeur assisté par plasma (ou PECVD pour « Plasma Enhanced Chemical Vapor Déposition » selon la terminologie anglaise), puis par le polissage mécano-chimique de la surface supérieure 431 de la couche diélectrique formée.

A l'issue de cette étape S304, la première partie 1a du premier résonateur 1 et la deuxième partie 2a du deuxième résonateur 2 sont formées sur la première face 131 de la couche piézoélectrique 13. Le substrat donneur 10 présente en outre une surface libre 431 plane et lisse, correspondant à la surface supérieure 431 de la couche diélectrique formée.

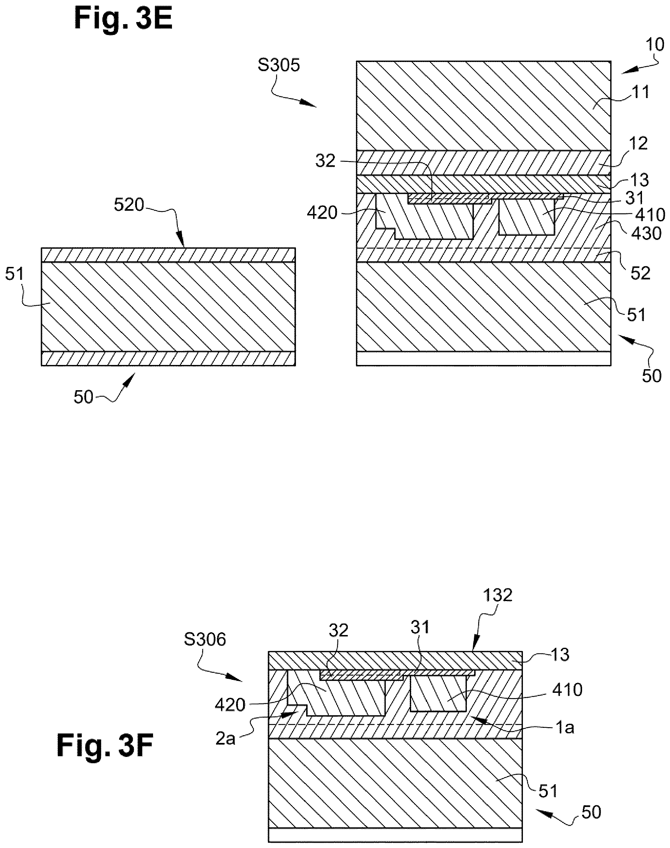

L'étape S305 qui suit l'étape S304 est illustrée en figure 3E. Elle vise à assembler par collage le substrat donneur 10 obtenu à l'issue de l'étape S304 sur un substrat receveur 50, avec les électrodes inférieures 31,32 (et les caissons de libération 410,420) disposées entre le substrat receveur 50 et le substrat donneur 10.

Le substrat receveur 50 est un substrat support en silicium 51 de haute résistivité (au minimum de 3 kΩ.cm, préférentiellement de plus de 10 kΩ.cm) recouvert d'une couche diélectrique 52, de préférence d'oxyde de silicium, lissée par polissage mécano-chimique.

L'étape S305 d'assemblage consiste d'abord à retourner le substrat donneur 10 obtenu à l'issue de l'étape S304 pour reporter la face libre 431 planarisée du dispositif formé par le substrat donneur 10 (cf. figure 3D) sur la face supérieure 520 du substrat receveur 50.

Ensuite, le collage direct est réalisé par un traitement thermique (ou recuit) dit de consolidation du collage.

L'étape suivante est l'étape S306 illustrée en figure 3F. Cette étape S306 consiste à retirer, sur l'assemblage formé à l'étape S305, la couche de substrat silicium 11 et la couche diélectrique 12 du substrat donneur 10. Pour cela, un rodage mécanique puis une gravure chimique dans une solution comprenant de l'hydroxyde de tetramethylammonium (ou TMAH pour « tetramethylammonium hydroxyde » selon la terminologie anglaise) sont effectués sur la couche de substrat silicium 11, et une gravure chimique à base de solution comprenant de l'acide fluorhydrique (HF) est effectuée sur la couche diélectrique 12.

A l'issue de l'étape S306, le substrat receveur 50 comprend la première partie 1a du premier résonateur 1, ainsi que la première partie 2a du deuxième résonateur 2 et présente en partie supérieure une face libre correspondant à la deuxième face 132 de la couche piézoélectrique 13.

En référence à la figure 3G, l'étape S307 consiste à former des ouvertures 136,137 à travers la couche piézoélectrique 13 à partir de la deuxième face 132. L'une des ouvertures 136 atteint les électrodes inférieures 31,32, et l'autre ouverture 137 atteint le caisson de libération 420. Une autre ouverture (non représentée sur la figure 3G) atteint le caisson de libération 410.

Pour cela, on procède à une photolithographie, puis à une gravure de la couche piézoélectrique par faisceau d'ion (ou IBE pour « Ion Beam Etching » selon la terminologie anglaise), puis à un retrait de résine.

L'étape S308 qui suit l'étape S307 est illustrée en figure 3H. Elle consiste à former l'électrode supérieure 33 du premier résonateur 1 ainsi que l'électrode supérieure 34 du deuxième résonateur 2.

De façon analogue à l'étape S303 de formation des électrodes inférieures 31,32, l'étape S308 comprend un dépôt d'une couche d'un matériau métallique, celui-ci étant choisi (mais non limité à) parmi les suivants : aluminium, molybdène, tungstène, ruthénium, iridium.

L'épaisseur de la couche de matériau métallique (et donc des électrodes supérieures 33,34) est par exemple 100 nm.

Les électrodes supérieures 33,34 sont avantageusement formées du même matériau métallique que les électrodes inférieures 31,32, par exemple d'aluminium.

Le dépôt de la couche métallique est suivi d'une opération de photolithographie comprenant le dépôt d'une résine, d'une opération de gravure humide dans une solution adaptée à la couche métallique, et d'une opération de retrait de la résine pour définir la forme des électrodes supérieures 33,34 du premier et du deuxième résonateur 1,2. En référence à la figure 3H, l'électrode supérieure 33 du premier résonateur 1 est séparée de l'électrode supérieure 34 du deuxième résonateur 2.

L'étape S309 suivante, illustrée en figure 3I, consiste en la libération des caissons de libération 410,420 par dissolution de la couche sacrificielle de silicium amorphe par du XeF₂ gazeux.

Ainsi, les caissons de libérations se remplissent d'air et forment les cavités d'air 41, 42 du premier et deuxième résonateur 1,2.

A l'issue de l'étape S309, la première partie 1a,1b du premier résonateur 1, et la deuxième partie 2a,2b du deuxième résonateur 2 sont réalisées, et le filtre passe-bande est réalisé.

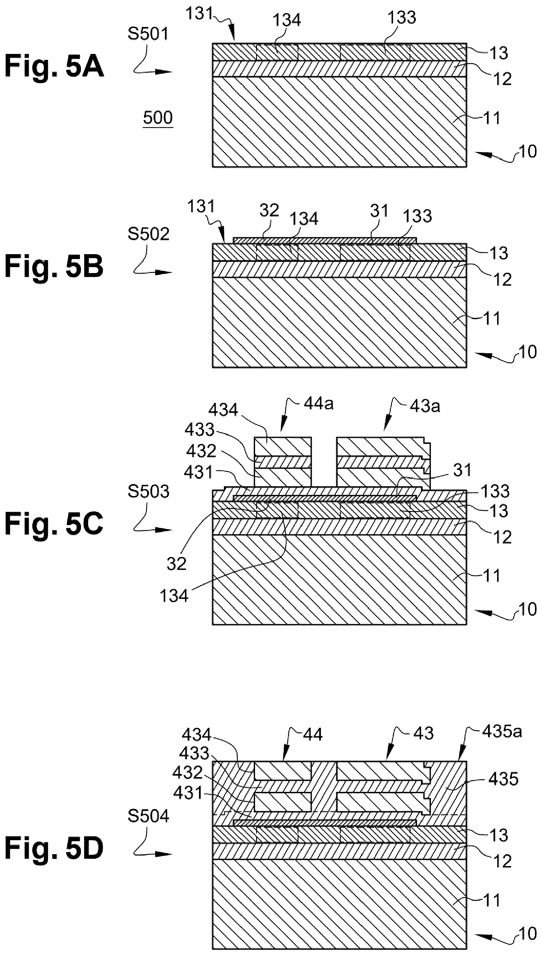

Les figures 5A à 5I représentent schématiquement des étapes d'un procédé 500 de réalisation selon un deuxième mode de réalisation de l'invention.

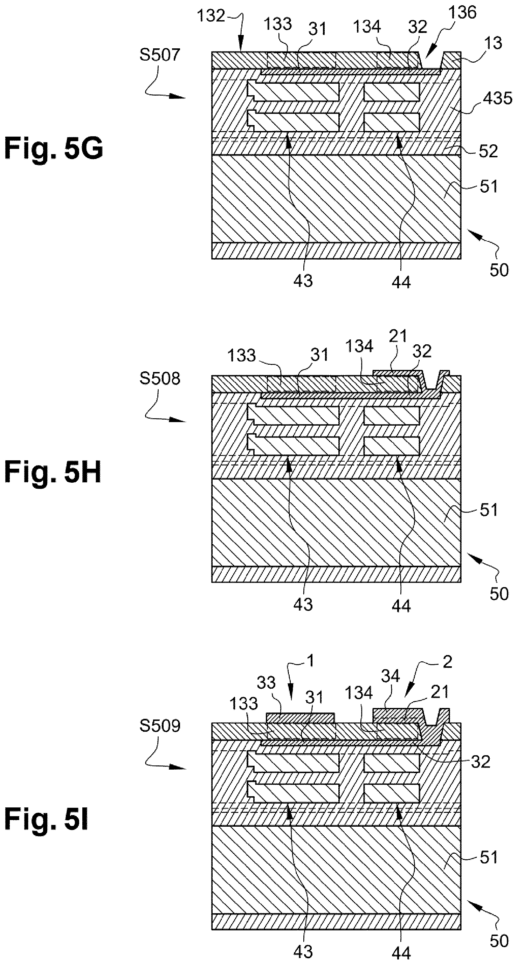

Selon ce deuxième mode de réalisation et en référence par exemple à la figure 5I, le premier et le deuxième résonateur 1,2 sont de type SMR, et le deuxième résonateur 2 reçoit une couche de surcharge massique 21 au niveau de son électrode supérieure 34.

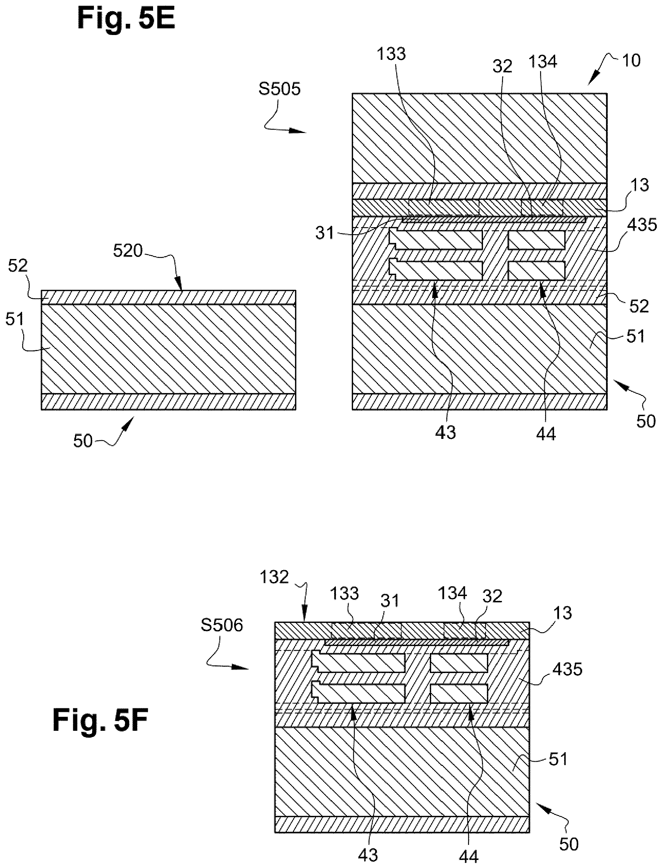

Le procédé 500 comprend les étapes S501, S502, S503, S504, S505, S506, S507, S508 et S509 représentées respectivement en figure 5A, en figure 5B, en figure 5C, en figure 5D, en figure 5E, en figure 5F, en figure 5G, en figure 5H et en figure 5I.

Les étapes S501, S502, S505, S506 et S509 sont respectivement analogues aux étapes S301, S303, S305, S306 et S308 du procédé 300 selon le premier mode de réalisation.

L'étape S507, illustrée en figure 5G diffère de l'étape S307 (cf. Figure 3G) uniquement par le fait qu'il n'y a que des ouvertures 136 atteignant les électrodes inférieures 31,32 et destinées à servir de via électrique à travers la couche piézoélectrique 13.

Le deuxième mode de réalisation (procédé 500) se distingue du premier mode de réalisation (procédé 300) de deux manières.

En premier lieu, l'étape S301 de formation d'un motif 20 de surcharge massique sur la première face 131 de la couche piézoélectrique 13 n'est pas réalisée mais est remplacée par l'étape S508 de formation d'un motif de surcharge massique 21 sur la deuxième face 132 (cf. figure 5F) de la couche piézoélectrique 13, au niveau de la deuxième zone 134.

Cette étape S508 est illustrée en figure 5H. Elle est réalisée dans le prolongement de l'étape S507 de formation d'une ouverture 136 à travers la couche piézoélectrique 13, et avant l'étape S509 de formation des électrodes supérieures 33,34 des résonateurs 1,2.

Le motif 21 de surcharge massique peut recouvrir l'ouverture 136, celle-ci étant formée à l'étape précédente S507 et étant destinée à relier l'électrode inférieure 32 du deuxième résonateur 2. Ainsi, le motif de surcharge massique 21 sert de via conducteur en même temps qu'il permet d'épaissir l'électrode supérieure 34.

L'étape S508 suit les mêmes sous-étapes S302A à S302D décrites précédemment et représentées en figure 4A, 4B, 4C et 4D. Ainsi, la formation du motif 21 de surcharge massique est effectuée sans endommager la deuxième face 132 de la couche piézoélectrique 13.

En second lieu, les étapes S304, S307 et S309 destinées à former les cavités d'air 41,42 (celles-ci permettant de former des résonateurs 1,2 de type FBAR) sont remplacées par les étapes S503 et S504. Celles-ci sont destinées à former les structures de Bragg 43,43 (cf. figure 5D) permettant de former les résonateurs 1,2 de type SMR (cf. figure 5I).

L'étape S503, illustrée en figure 5C, est destinée à débuter la formation des structures de Bragg 43, 43.

Précisément, l'étape S503 consiste en la formation d'un empilement de couches 43a sur l'électrode inférieure 31 du premier résonateur 1 et d'un empilement de couches 44a sur l'électrode inférieure 32 du deuxième résonateur 2.

L'étape S503 comprend pour cela les sous-étapes successives suivantes :
- Dépôt d'une première couche 431 d'oxyde de silicium sur toute la surface de la couche piézoélectrique 13, la première couche 431 recouvrant les électrodes inférieures 31, 32 du premier et deuxième résonateur 1,2.
- Dépôt d'une deuxième couche 432 de tungstène sur la première couche 431. Une couche d'accroche en titane, oxyde de titane, nitrure de titane ou tout autre matériau connu de l'état de l'art peut être préalablement déposée.
- Définition de la deuxième couche 432 pour débuter la formation de l'empilement 43a au niveau de la première zone 133 et du deuxième empilement 44a au niveau de la deuxième zone 134. Pour cela, une combinaison de photolithographie, et de gravure sèche, par exemple par gravure ionique réactive (ou RIE pour « Reactive Ion Etching » selon la terminologie anglaise) est réalisé.
- Dépôt d'une troisième couche 433 d'oxyde de silicium sur la deuxième couche 432.
- Dépôt d'une quatrième couche 434 en tungstène sur la troisième couche 433. Comme précédemment, une couche d'accroche en titane, oxyde de titane, nitrure de titane ou tout autre matériau connu de l'état de l'art peut être préalablement déposée.
- Définition de la quatrième couche 434 pour continuer le premier empilement 43a et le deuxième empilement 44a par une combinaison de photolithographie et de gravure sèche.
- Retrait de la résine ayant servi pour la photolithographie.

La première, deuxième, troisième et quatrième couches 431,432,433 et 434 forment les miroirs de Bragg des structures de Bragg 43,44.

De manière alternative, il est possible de former les structures de Bragg 43 et 44 en ne procédant qu'à une unique étape de gravure simultanée des couches métalliques 432 et 434 ainsi que de la couche diélectrique intermédiaire 433. Pour cela, on utilise la succession de sous-étapes suivantes :
- Dépôt d'une première couche 431 d'oxyde de silicium sur toute la surface de la couche piézoélectrique 13, la première couche 431 recouvrant les électrodes inférieures 31, 32 du premier et deuxième résonateur 1,2.
- Dépôt d'une deuxième couche 432 de tungstène sur la première couche 431. Une couche d'accroche en titane, oxyde de titane, nitrure de titane ou tout autre matériau connu de l'état de l'art peut être préalablement déposée.
- Dépôt d'une troisième couche 433 d'oxyde de silicium sur la deuxième couche 432.
- Dépôt d'une quatrième couche 434 en tungstène sur la troisième couche 433. Comme précédemment, une couche d'accroche en titane, oxyde de titane, nitrure de titane ou tout autre matériau connu de l'état de l'art peut être préalablement déposée.
- Définition des miroirs de Bragg par photolithographie et gravure par faisceau d'ions des quatrième, troisième et seconde couches 434, 433 et 432 pour continuer le premier empilement 43a et le deuxième empilement 44a.
- Retrait de la résine ayant servi pour la photolithographie.

L'étape S504, illustrée en figure 5D, consiste en un dépôt d'une couche épaisse 435, de 2.5 µm par exemple par PECVD, d'oxyde de silicium sur le substrat donneur 10.

La couche 435 d'oxyde de silicium recouvre entièrement les empilements 43a, 44a formés à l'étape S503 et présente une surface supérieure 435a.

Un contre-masque peut être employé à cette étape S504. Il comprend une combinaison de photolithographie et de gravure partielle de la couche 435 d'oxyde de silicium et de retrait de résine pour égaliser le niveau de la surface supérieure 435a entre le sommet des miroirs de Bragg et les zones environnantes.

Cette surface est ensuite planarisée par polissage avec arrêt sur la quatrième couche 434.

Ainsi, le procédé 500 selon ce deuxième mode de réalisation concerne la réalisation d'un filtre passe-bande utilisant des résonateurs de type SMR, et comprend, avant la formation des électrodes supérieures 33,34, la formation d'un motif 21 de surcharge massique intercalé entre la couche piézoélectrique 13 et l'électrode supérieure 34 du deuxième résonateur SMR. L'avantage de procéder de la sorte par rapport à disposer la couche de surcharge massique entre la couche piézoélectrique 13 et l'électrode inférieure 31 est de simplifier la sous-étape de polissage de l'étape 504, puisque l'absence de la couche de surcharge massique sous l'électrode inférieure assure que les surfaces supérieures des structures 43 et 44 sont localisées à la même hauteur.

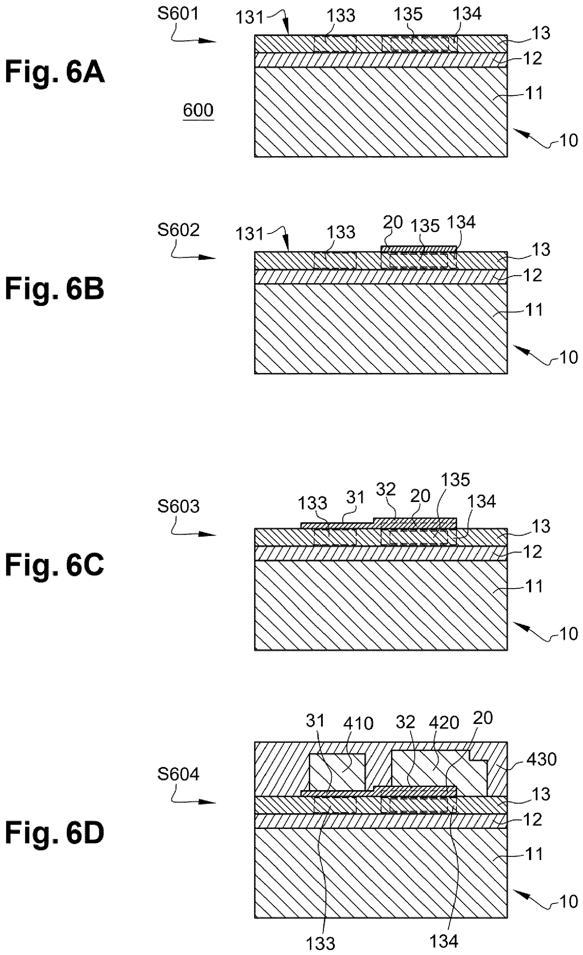

Les figures 6A à 6J représentent schématiquement des étapes d'un procédé 600 de réalisation selon un troisième mode de réalisation de l'invention.

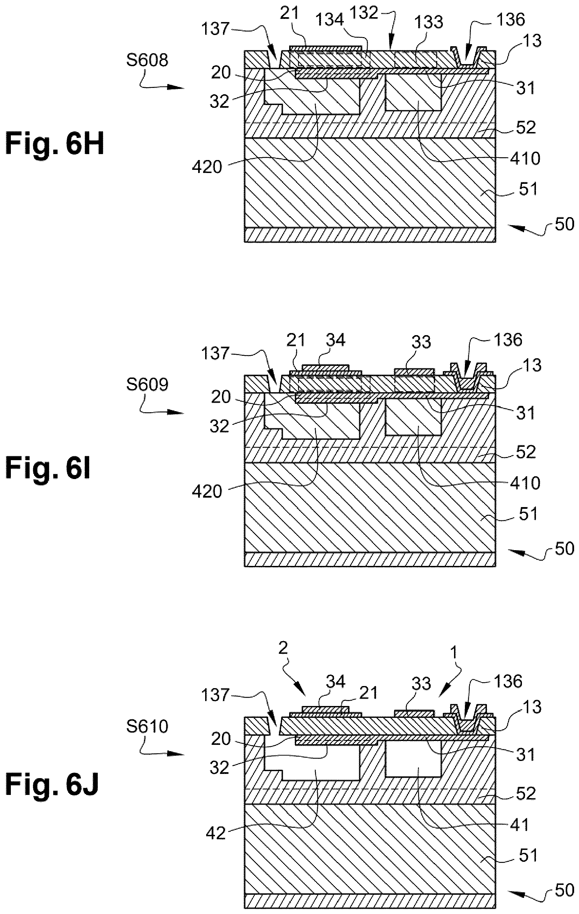

Selon ce troisième mode de réalisation, le premier et le deuxième résonateur 1,2 sont de type FBAR (cf. figure 6J), et le deuxième résonateur 2 reçoit une couche de surcharge massique 20 au niveau de son électrode inférieure 32 et une couche de surcharge massique 21 au niveau de son électrode supérieure 34. Avantageusement, ces couches de surcharge massiques 21,22 sont formées d'un même matériau métallique, par exemple de l'aluminium, et sont d'épaisseur identiques, égale à la moitié de l'épaisseur totale nécessaire pour atteindre le décalage fréquentiel désiré pour la fréquence de résonance du deuxième résonateur 2.

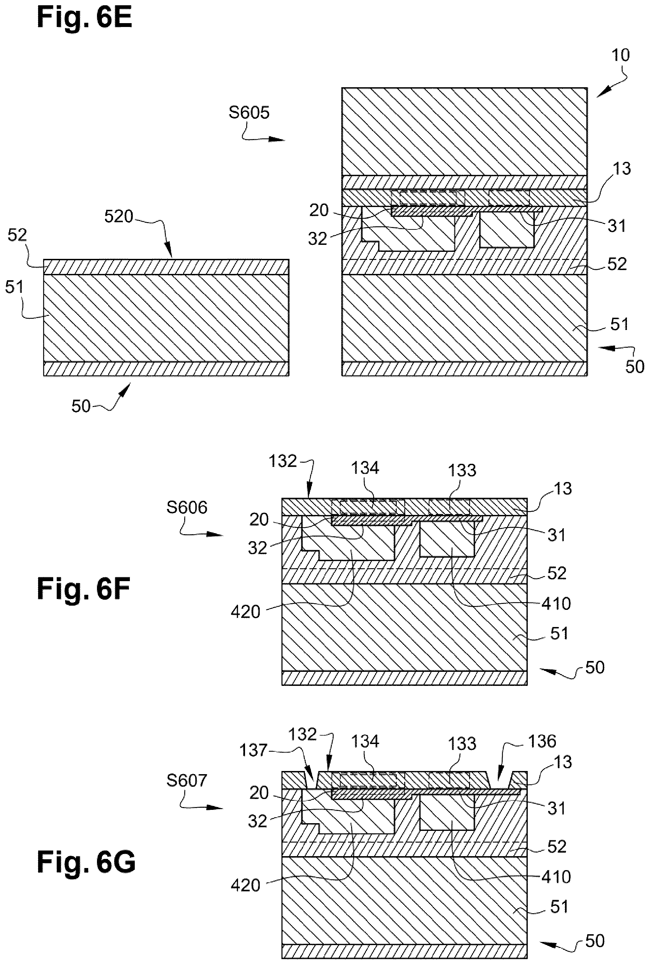

Le procédé 600 comprend les étapes S601, S602, S603, S604, S605, S606, S607, S608, S609 et S610 représentées respectivement en figure 6A, en figure 6B, en figure 6C, en figure 6D, en figure 6E, en figure 6F, en figure 6G, en figure 6H, en figure 6I et en figure 6J.

Les sept premières étapes S601, S602, S603, S604, S605, S606, S607 sont identiques aux sept premières étapes S301, S302, S303, S304, S305, S306, S307 illustrées en figures 3A, 3B, 3C, 3D, 3E, 3F, et 3G.

Les étapes S601 à S607 permettent ainsi d'aboutir au même dispositif (cf. figure 6G) que celui représenté en figure 3G.

L'étape S610 illustrée en figure 6J est par ailleurs identique à l'étape S309 illustrée en figure 3I.

Le procédé 600 selon le troisième mode de réalisation se distingue du procédé 300 selon le premier mode de réalisation en ce qu'il comporte une étape S608 de formation d'un ou plusieurs motifs 21 de surcharge massique sur la deuxième face 132 de la couche piézoélectrique 13, au niveau de la deuxième zone 134 (cf. Figure 6H). Cette étape S608 est analogue à l'étape S507 représentée en figure 5G du procédé 500 selon le deuxième mode de réalisation.

Avantageusement, les motifs 20 et 21 de surcharge massique sont formés du même matériau métallique et sont d'épaisseur identiques. Ainsi, la surcharge massique est répartie et disposée de façon symétrique par rapport à la couche piézoélectrique.

Ce troisième mode de réalisation trouve un avantage particulier lorsque l'on souhaite synthétiser un filtre très large bande (par exemple 600 MHz). En effet, pour ces valeurs de largeur de bandes, le décalage fréquentiel nécessite d'utiliser des épaisseurs de couche massique supérieures à 150 nm. Une telle épaisseur, si elle est réalisée qu'avec un seul motif de surcharge massique peut entraîner une asymétrie dans l'empilement formant le deuxième résonateur 2. Cette asymétrie favorise l'excitation de modes de vibration asymétriques, tels que la résonance d'ordre 2, qui entrainent une moins bonne réjection, c'est-à-dire une atténuation plus faible, en dehors de la bande passante. En répartissant l'épaisseur de couche de surcharge de façon symétrique sur deux motifs de surcharge massique, le troisième mode de réalisation pallie cet inconvénient.

De façon commune aux trois modes de réalisation qui viennent d'être décrits, des étapes optionnelles peuvent être réalisées en fin de procédé, c'est-à-dire après l'étape S309 du procédé 300, ou après l'étape S509 du procédé 500, ou après l'étape S610 du procédé 600.

Ces étapes, non représentées, consistent, entre autres,
- à ajouter une couche de passivation au-dessus des électrodes supérieures 33,34, sur la deuxième face 132 (cf. figure 3I par exemple), cette couche de passivation définissant la dernière couche (ou couche supérieure) du filtre. La couche de passivation permet de protéger les résonateurs 1,2 de l'environnement ambiant et ainsi d'améliorer leur fiabilité sur le long terme. La couche de passivation est formée d'un diélectrique, par exemple de dioxyde de silicium.
- à former une couche métallique, dite couche de sur-métallisation sur la deuxième face 132 (cf. figure 3I), cela uniquement au niveau de l'électrode supérieure 33 du premier résonateur 1 et uniquement au niveau de l'électrode supérieure 34 du deuxième résonateur 2. Au niveau des résonateurs 1,2, cette couche de sur-métallisation n'enrobe en aucune façon les zones situées en dehors des électrodes supérieures 33,34. La formation de la couche métallique comprend une combinaison de photolithographie, de gravure et de retrait de résine. Elle vise à consolider les électrodes 33,34 électriquement (la couche métallique limite les pertes résistives des électrodes supérieures 33,34).

Pour les résonateurs de type FBAR, on peut également prévoir de former une couche de passivation par-dessous les électrodes inférieures 31,32, cela en plus de la couche de passivation décrite ci-dessus, dans le but d'encapsuler le filtre des deux côtés.

Les différents modes de réalisation décrivent un filtre comprenant deux résonateurs à ondes acoustiques de volume. Naturellement, le procédé selon l'invention s'applique à un filtre comprenant plusieurs résonateurs à ondes acoustiques de volume, par exemple entre trois et neuf résonateurs.

Le procédé de réalisation (300,500,600) selon l'invention permet de réaliser un filtre large bande adapté aux nouvelles générations de communication mobile en améliorant les techniques de l'art antérieur, notamment en permettant d'utiliser des matériaux piézoélectriques monocristallins et en permettant de modifier de façon plus importante la fréquence d'un résonateur à ondes acoustiques de volume (de type FBAR ou SMR), cela en préservant le coefficient de couplage électromécanique et les électrodes des résonateurs.

## Revendications

1. Procédé (300,500,600) de réalisation d'un filtre passe-bande comprenant un premier résonateur (1) à ondes acoustiques de volume et un deuxième résonateur (2) à ondes acoustiques de volume, la fréquence de résonance du deuxième résonateur étant décalée de la fréquence de résonance du premier résonateur avec un décalage prédéterminé, le procédé (300,500,600) comprenant les étapes de :
- fourniture (S302, S502, S602) d'un substrat (10) piézoélectrique sur isolant, dit substrat donneur (10), comprenant en partie supérieure une couche piézoélectrique (13),
- formation (S303, S502, S603) d'une électrode inférieure (31) du premier résonateur (1) sur une première zone (133) prédéfinie de la couche piézoélectrique (13), et d'une électrode inférieure (32) du deuxième résonateur (2) sur une deuxième zone (134) prédéfinie de la couche piézoélectrique (13),
- assemblage (S305, S505, S605) par collage du substrat donneur (10) sur un substrat receveur (50), de sorte que les électrodes inférieures (31,32) des premier et deuxième résonateurs (1,2) sont disposées entre le substrat receveur (50) et le substrat donneur (10),
- retrait (S306, S606), dans l'assemblage du substrat receveur (50) et du substrat donneur (10), du substrat donneur (10) avec arrêt sur la couche piézoélectrique (13),
- formation (S308, S509, S609) sur la couche piézoélectrique (13), d'une électrode supérieure (33) du premier résonateur (1) au niveau de la première zone (133), et d'une électrode supérieure (34) du deuxième résonateur (2) au niveau de la deuxième zone (134),
la formation (S303, S502, S603) des électrodes inférieures (31,32) étant précédée d'une étape de formation (S302, S602) d'un motif de surcharge massique (20) au niveau de la deuxième zone (134), dit motif (20) de surcharge massique de l'électrode inférieure,
et/ou la formation (S308, S509, S609) des électrodes supérieures (33,34) étant précédée d'une étape de formation (S508, S608) d'un motif (21) de surcharge massique au niveau de la deuxième zone, dit motif (21) de surcharge massique de l'électrode supérieure,
l'épaisseur totale du ou des motifs (20,21) de surcharge massique étant choisie pour décaler la fréquence de résonance du deuxième résonateur avec le décalage prédéterminé,
chaque motif (20,21) de surcharge massique étant formé par lift-off d'une couche sacrificielle (210) formée préalablement sur la couche piézoélectrique (13).

2. Procédé selon la revendication 1 dans lequel la formation (S302, S602, S508, S608) de chaque motif (20,21) de surcharge massique comprend les sous-étapes suivantes :
- dépôt (S302A, S302B) d'une couche sacrificielle (210) sur toute la surface de la couche piézoélectrique (13),
- définition d'une ouverture (220) à travers la couche sacrificielle au niveau de la deuxième zone (134), l'ouverture débouchant sur la couche piézoélectrique (13) au niveau de ladite deuxième zone (134),
- dépôt (S302C) d'une couche (230) de surcharge massique de sorte à recouvrir la couche piézoélectrique uniquement au niveau de l'ouverture (136) et recouvrir la couche sacrificielle (210) en dehors de l'ouverture (136),
- retrait (S302D) de l'empilement formé par la couche sacrificielle (210) et la couche de surcharge massique (230) par retrait par lift-off de la couche sacrificielle (210), ledit retrait laissant la couche de surcharge massique (230) sur la couche piézoélectrique (13) uniquement au niveau de la deuxième zone (134) pour former le motif (21,21) de surcharge massique.

3. Procédé (300,500,600) selon l'une des revendications 1 à 2 dans lequel le motif (20) de surcharge massique de l'électrode inférieure est formé d'un matériau identique au motif (21) de surcharge massique de l'électrode supérieure et présente une épaisseur identique audit motif (21) de surcharge massique de l'électrode supérieure.

4. Procédé (300,500,600) selon l'une des revendications 1 à 3 dans lequel le motif (20) de surcharge massique de l'électrode inférieure est formé d'un matériau identique au matériau des électrodes inférieures (31,32), et le motif (21) de surcharge massique de l'électrode supérieure est formé d'un matériau identique au matériau des électrode supérieures (33,34), et dans lequel la deuxième zone (134) est latéralement plus étendue que le deuxième résonateur (2).

5. Procédé (300,500,600) selon l'une des revendications 1 à 4 dans lequel la couche piézoélectrique (13) est formée d'un matériau piézoélectrique monocristallin.

6. Procédé (300,500,600) selon la revendication 5 dans lequel le matériau piézoélectrique monocristallin est choisi parmi l'un des matériaux suivants : niobate de lithium, tantale de lithium, niobate de potassium, et de scandium monocristallin.

7. Procédé (300,500,600) selon l'une des revendications 1 à 6 dans lequel les électrodes inférieures (31,32) et supérieures (33,34) sont formées de l'un des matériaux suivants : aluminium, molybdène, tungstène, ruthénium, iridium.

8. Procédé (300,500,600) selon l'une des revendications 1 à 7 comprenant une étape de formation (S503) d'une structure de Bragg (42) sur l'électrode inférieure (31) du premier résonateur (1) et d'une structure de Bragg (43) sur l'électrode inférieure (32) du deuxième résonateur (2), ladite étape de formation (S503) des structures de Bragg (43,44) étant réalisée entre la formation (S502) des électrodes inférieures et l'étape d'assemblage (S505).

9. Procédé (300,500,600) selon l'une des revendications 1 à 7 comprenant des étapes (S304, S306, S309) pour former une cavité d'air (41) du premier résonateur (1) et une cavité d'air (42) du deuxième résonateur (2), lesdites étapes (S304, S306, S309) étant les suivantes :
- entre la formation (S303) des électrodes inférieures (31, 32) et l'étape d'assemblage (S305), formation (S304) d'un caisson (410) sur et autour de l'électrode inférieure (31) du premier résonateur (1), et d'un caisson (420) sur et autour de l'électrode inférieure (32) du deuxième résonateur (2), les caissons (410,420) comprenant une couche sacrificielle,
- après l'étape d'assemblage (S305) et avant la formation (S308) des électrodes supérieures, formation (S306) à travers la couche piézoélectrique (13) d'une ouverture (137) pour atteindre le caisson (410) situé sur et autour de l'électrode inférieure du premier résonateur (1), et d'une ouverture pour atteindre le caisson (420) situé sur et autour de l'électrode inférieure du deuxième résonateur (2),
- après l'étape de formation (S308) des électrodes supérieures, retrait (S309) de la couche sacrificielle au travers des ouvertures pour libérer les caissons (410,420) et les emplir d'air.

10. Procédé (300,500,600) selon l'une des revendications 1 à 9, comprenant, après l'étape de formation (S309, S508, S609) des électrodes supérieures (33,34), une étape supplémentaire de dépôt en face supérieure (132) du filtre passe-bande et uniquement sur les électrodes supérieures (33,34), d'une couche métallique, dite couche de sur-métallisation.
